(19) Europäisches Patentamt

European Patent Office

Office européen des brevets

(11) **EP 2 172 974 A1**

(12) **EUROPEAN PATENT APPLICATION**

(43) Date of publication:
**07.04.2010 Bulletin 2010/14**

(21) Application number: **08290924.3**

(22) Date of filing: **01.10.2008**

(51) Int Cl.:
***H01L 27/146*** (2006.01)      ***H01L 31/0232*** (2006.01)
***H01L 31/0352*** (2006.01)

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **NXP B.V.**
**5656 AG Eindhoven (NL)**

(72) Inventor: **The designation of the inventor has not yet been filed**

(74) Representative: **Vignesoult, Serge L. M. et al**
**Cabinet Plasseraud**
**52, rue de la Victoire**
**75440 Paris Cedex 09 (FR)**

(54) **Wavelength selective electromagnetic radiation detector using pores as photonic crystal**

(57)     A device (100) for detecting electromagnetic radiation, the device (100) comprising a substrate (102), an electromagnetic radiation sensitive structure (104) arranged on and/or in the substrate (102), and a plurality of pores (106) formed on and/or in the substrate (102) in such a manner that electromagnetic radiation to be detected propagates partly through the pores (106) before propagating into the electromagnetic radiation sensitive structure (104), wherein different ones of the plurality of pores (106) differ regarding at least one physical parameter so that each of the plurality of pores (106) is sensitive to an assigned wavelength range of electromagnetic radiation.

Fig. 6

EP 2 172 974 A1

**Description**

FIELD OF THE INVENTION

The invention relates to a device for detecting electromagnetic radiation.
Moreover, the invention relates to a method of detecting electromagnetic radiation.

BACKGROUND OF THE INVENTION

A PIN (P-type/Intrinsic/N-type or positive intrinsic negative) diode can be used as a photodiode. Under reverse bias, the diode ordinarily does not conduct. A photon entering the intrinsic region frees a carrier. The reverse bias field sweeps the carrier out of the region and creates a current. In order to make a wavelength detector, it may be necessary to filter the light before it reaches the intrinsic region.
US 5,726,440 discloses a wavelength selective photodetector including a substrate having a buried insulator layer for electrically isolating a lower section of the substrate located below the insulator layer from an upper section of the substrate located above the insulator layer, and a photon detector formed on the upper section of the substrate for detecting photons in a selected wavelength range, wherein the upper section has a selected thickness and the thickness determines at least in part the selected wavelength range of the detected photons.
However, conventional wavelength selective photodetectors may lack sufficient detection accuracy.

OBJECT AND SUMMARY OF THE INVENTION

It is an object of the invention to enable electromagnetic radiation detection with sufficient accuracy.
In order to achieve the object defined above, a device for detecting electromagnetic radiation, and a method of detecting electromagnetic radiation according to the independent claims are provided.
According to an exemplary embodiment of the invention, a device for detecting electromagnetic radiation (such as light) is provided, the device comprising a substrate (such as a semiconductor wafer), an electromagnetic radiation sensitive structure (such as a photodiode) arranged on and/or in the substrate, and a plurality of pores (such as empty or filled trenches in a surrounding material) formed on and/or in the substrate in such a manner that electromagnetic radiation to be detected propagates through at least a part of the plurality of pores (for instance may be reflected once or several times at walls thereof) before propagating into (or penetrating into) the electromagnetic radiation sensitive structure (which structure may be arranged to extend deeper into the substrate or with a larger distance to a surface of the device, which surface is to be irradiated with the incoming electromagnetic radiation, than the plurality of pores), wherein different ones of the plurality of pores differ regarding at least one physical parameter so that each of the plurality of pores is sensitive to an assigned wavelength range of electromagnetic radiation (wherein assigned wavelength ranges of different pores or pore groups may be different or may be at least overlapping).
According to another exemplary embodiment of the invention, a method of detecting electromagnetic radiation is provided, the method comprising directing electromagnetic radiation to be detected towards a plurality of pores formed on and/or in a substrate in such a manner that the electromagnetic radiation to be detected propagates through at least a part of the plurality of pores, and subsequently propagating the electromagnetic radiation into an electromagnetic radiation sensitive structure arranged on and/or in the substrate, wherein different ones of the plurality of pores differ regarding at least one physical parameter so that each of the plurality of pores is sensitive to an assigned wavelength range of the electromagnetic radiation.
The term "substrate" may denote any suitable material, such as a semiconductor, glass, plastic, etc. According to an exemplary embodiment, the term "substrate" may be used to define generally the elements for layers that underlie and/or overlie a layer or portions of interest. Also, the substrate may be any other base on which a layer is formed.
The term "electromagnetic radiation" may particularly denote photons in an appropriate wavelength range. In an embodiment, such an electromagnetic radiation may be in a range between 400 nm and 800 nm, so that optical light is the electromagnetic radiation then. However, alternatively, other wavelength ranges are possible such as ultraviolet radiation, infrared radiation or the like. For instance for silicon, a usable electromagnetic radiation range goes from 190 nm to 1100 nm. However, with other materials for photodetectors, ranges can be different and may, for example, be extended to far infrared or far ultraviolet.
The term "pore" may particularly denote a trench formed in and/or on a substrate and having an aspect ratio, which is defined by the ratio between depth of the trench in the substrate and diameter of the trench in a surface portion of the substrate. For instance, such pores may have a cylindrical shape or alternatively may have a rectangular cross section, an oval cross section, a polygonal cross section or the like. In an embodiment, the aspect ratio may be larger than three, particularly larger than five, more particularly larger than ten. A diameter of the pores may be less than 1000 nm, particularly less than 700 nm. Generally, it may be advantageous to use, as a diameter dimension, a value in the order of the wavelength to get a sufficiently pronounced diffraction effect. For instance, a 700 nm hole may particularly impact radiation of about 700 nm wavelength. The term "electromagnetic radiation sensitive structure" may particularly denote a member, which is capable of detecting electromagnetic radiation such as a CMOS sensor, a CCD pixel, or the like. For instance, photodiodes (such as a simple pn-junction) may be used for such detection purposes. However, alternative detection options are possible as well.

The term "physical parameter" may particularly denote any physical or structural or dimensional property of the pores, which may have an impact on the propagation characteristics of electromagnetic radiation of a certain wavelength in the pore. Such a physical parameter may change the propagation characteristics of electromagnetic radiation depending on the wavelength of the electromagnetic radiation. Examples for such a physical property are a diameter of the pores, a geometry of the pores, a depth of the pores, an aspect ratio of the pores, a surface area of the pores, a material filled in the pores, etc.

According to an exemplary embodiment, the detection of electromagnetic radiation in a wavelength specific manner is possible. For this purpose, pores having different physical parameters such as geometrical parameters or material parameters may be provided, for example pores having different diameters. The propagation properties of the electromagnetic radiation within the pores may depend particularly on the wavelength of the electromagnetic radiation so that each of the pores may be used as a wavelength specific filter being sensitive only to electromagnetic radiation in a specific wavelength range or of a specific wavelength. Thus, by providing multiple pores having different physical properties, each pore may be used as a band-pass filter in a dedicated or assigned wavelength range.

In an embodiment, a wavelength detector in silicon may be provided. Such an embodiment may combine a PIN (P-type/Intrinsic/N-type or positive intrinsic negative) diode with pore technology to manufacture the wavelength detector. A gist of an embodiment is to make holes of different diameters in a vertical PIN structure and to use diffraction to select wavelength and recombination of electron-hole pair in the intrinsic region.

With silicon electronics, it is possible to make a wavelength detector performing a feedback loop function on a complete solid state lighting solution. Phototransistors may serve as a good detector, but have a low internal gain (compared to a photodiode). So a large area may be necessary. Embodiments of the invention may allow making very small wavelength detectors in silicon that can be integrated in a small package. The trend to use solid-state lighting like LEDs is increasing as it has a very small footprint and is very efficient. Their major drawback is the intensity variation due to environmental factors like temperature, aging, etc. By putting a very small light detector near the light source (a mobile phone flash for example), this can control a feedback loop to control the intensity or wavelength of the light flux. It is also possible to integrate embodiments of the detector with passive electronics and with LED drivers to obtain a low cost solution. A corresponding packaging may be more reliable and smaller and may be simple in manufacture.

Because of integration of sensor and LEDs, calibration may be done by manufacturers and not by an end user who is buying LED and sensors separately. The benefit of a PIN diode is that the depletion region exists almost completely within the intrinsic region, which is a constant width (or almost constant) regardless of the reverse bias applied to the diode. This intrinsic region can be made large, increasing the area where electron-hole pairs can be generated. For these reasons many photodetector devices may include at least one PIN diode in their construction, for example PIN photodiodes and phototransistors (in which the base-collector junction is a PIN diode).

Next, further exemplary embodiments of the device will be described. However, these embodiments also apply to the method.

The plurality of pores may be formed to extend parallel to one another. For example, the pores may be arranged in a row or in a matrix-like manner on a surface of the substrate. An alignment direction of the pores may be parallel to one another and perpendicular to a surface of the substrate so that the manufacture of all pores is possible with a common lithography procedure. The electromagnetic radiation to be detected may be directed perpendicular to the surface of the substrate or basically parallel to an alignment of the pores.

Different ones of the plurality of pores may have a different diameter or a different surface area in a surface plane of the substrate, which surface is to be irradiated with the incoming electromagnetic radiation. For example, first pores may have a first diameter, second pores may have a second diameter differing from the first diameter, third pores may have a third diameter differing from the first and the second diameter, etc. In this context, a diameter may be the diameter of a circle in a surface of the pore, may be the length of a diagonal of a rectangle, or the like.

Different ones of the plurality of pores may extend up to a different depth into the substrate, which depth may be calculated as a distance from a surface to be irradiated with the incoming electromagnetic radiation. Also by modifying the depth up to which the pores extend into the substrate, the wavelength specific propagation characteristic of the different pores may be further refined, involving another design parameter for a wavelength filter or a wavelength specific detector. For example, by using different aspect ratios for the different pores, it is possible that some of the pores extend into layers into which other pores do not extend. This may allow to define the specific wavelength selective properties with high accuracy.

A cross-section of the pores may be constant along the extension of the pores into the substrate.

The plurality of pores may be grouped into groups of pores. Pores of each one of the groups may have a common diameter in a surface plane of the substrate and may extend up to a different depth into the substrate. Hence, for the different pores of a common group, the same pore diameter may be used but different extensions in a vertical direction. On the other hand, pores of different ones of the groups may have a different diameter in a surface plane of the substrate. Hence, a two-dimensional array of pores may be provided, wherein one design parameter is the diameter and another design parameter is the depth up to which the pores extend into the substrate. By taking this measure, a highly wavelength selective filter may be obtained.

The plurality of pores may be trenches extending perpendicular with respect to a main surface of the substrate. The main surface may be the surface at which a semiconductor wafer is usually processed. Vertical pores can be formed in such a semiconductor substrate as trenches by a lithography and etching procedure.

The plurality of pores may be at least partially filled with a filling material being transparent for the electromagnetic radiation, particularly being optically transparent. Such a material, for instance silicon dioxide as a CMOS compatible material, may fill the pores so that the device is not prone to dust or dirt. However, other materials may be appropriate as well, for instance a silicon filled material such as polysilicon. More generally, any appropriate semiconductor material such as polysilicon, silicon dioxide, silicon nitride, germanium, may be used. Hence, the filling material may be selected so as to not influence the detection purposes, but to provide for a mechanical stable structure, which can even be employed under harsh conditions. In another embodiment, the filling material of the pores may be used as a design parameter for adjusting the wavelength-dependent propagation properties of the pores. In still another embodiment, the pores may remain unfilled, that is may remain hollow bodies.

The electromagnetic radiation sensitive structure may comprise a photodiode structure, particularly a photodiode such as a PIN photodiode or a PN photodiode. Such a structure can be formed as a layer structure with simple deposition procedures known from semiconductor technology, wherein an orientation of such layers may be perpendicular to an extension of the trenches as the pores. A photodiode can simply be formed by correspondingly doping different portions of a semiconductor substrate, thereby providing for a pn-junction. Upon irradiation with electromagnetic radiation such as light, electron-hole pairs may be generated at the pn-junction, which can be detected as a fingerprint of the presence of the corresponding electromagnetic radiation.

The electromagnetic radiation sensitive structure may comprise a stack of layers differing regarding a doping profile of the respective layer, wherein the plurality of pores may be formed to penetrate through at least a part of the layers. For example, the layers may be planar layers which are formed on top of the substrate, and the pores may be formed at least partially in this layer stack perpendicular to a sequence of application of the layers. By taking this measure, simple and well-known manufacture procedures of silicon technology may be employed and simultaneously a powerful wavelength selective filter may be formed.

A thickness of at least a part of the layers may differ in portions adjacent to different ones of the plurality of pores. By forming the layers of different thicknesses, it is possible that adjacent pores are neighboured to different thicknesses of a respective material, for instance an n-doped material and/or a p-doped material. This may have an influence on the interaction between surrounding matter and the electromagnetic radiation, thereby further refining the wavelength selectivity of the system.

The device may comprise a patterned cover layer arranged to expose the plurality of pores and to cover surface portions between adjacent ones of the plurality of pores. Such a patterned cover layer may be arranged on top (or close to the top) of the layer sequence forming the device and may prevent electromagnetic radiation from propagating into portions between adjacent pores, which could deteriorate the detection performance.

Such a cover layer may, for instance, have electrically conductive properties so as to allow serving as electrodes for the photodiodes as well. When such a cover layer is made of an opaque material, it can have a shielding effect preventing optical light to propagate through portions between the pores, which could result in undesired crosstalk.

It is also possible to provide a cover layer made of an anti-reflective material (at least above the pores) so as to prevent reflection of electromagnetic radiation to thereby improve the detection efficiency. Hence, the amplitude of the detection signals may be kept sufficiently large.

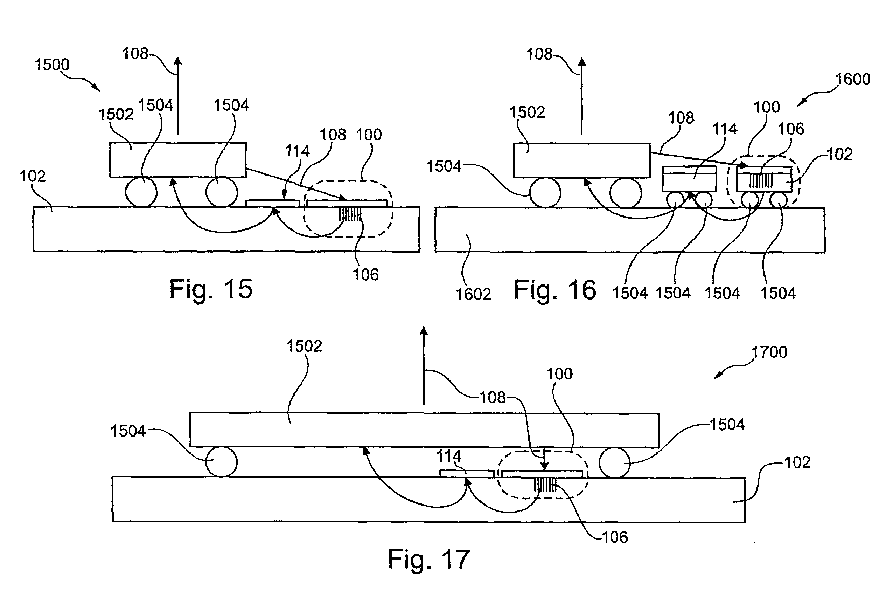

The device may comprise a signal processing circuit formed on and/or in the substrate and being adapted for processing detection signals generated by the electromagnetic radiation sensitive structure. Such a signal processing circuit may be monolithically integrated within the substrate and may comprise active and/or passive electric components, for instance may comprise resistors, capacitances, transistors, logic gates, memory cells, processors, or the like. Hence, it is possible that the signal processing circuit processes the signal provided by the electromagnetic radiation sensitive structure to evaluate the wavelength dependence of the impinging electromagnetic radiation. In an embodiment (see for instance Fig. 15), all devices are fully integrated on a silicon wafer. This may be called SoC (System on Chip). SoC is advantageous regarding parasitic effects. In another embodiment (see Fig. 16), devices are mounted on a support, this may be called SiP (System in Package). SiP may be preferred for ease of process.

In an embodiment, the electromagnetic radiation sensitive structure may be realized as a photodiode which may be electrically biased by a bias voltage to enable accurate detection of electric signals in response to the presence of electromagnetic radiation.

For example, the device may additionally comprise an electromagnetic radiation source such as a light emitting diode (LED) which may be adapted for generating electromagnetic radiation such as light and may be controlled by a control signal generated by the signal processing circuit based on the detection signals. Hence, a combined light emitting diode and photodetector may be manufactured which allows to regulate the emission characteristics of the light emitting diode based on the detected signal of the light emitting diode which allows for a wavelength specific analysis of the emission characteristic of the light source.

For example, the device may be monolithically integrated in and/or on the substrate. Hence, at least a part of the components of the device may be manufactured in semiconductor technology or microprocessing technology and the resulting system may be very small in size.

An embodiment of the invention may use the fundamental physical laws of diffraction of light in a hole combining to a vertical PIN diode. Choosing the right design and silicon electronics can result in a variety of devices. In an embodiment, it is possible to make a specific wavelength detector with two different diameters only. Other possible applications are a wide range light detector to measure the absolute intensity of a light source. For example, it can be used to tune the flash intensity by a feedback loop. Another application is a light filter for wavelengths below or above a specific value. If the detector is used for a non-mobile application, the detector can be put far away from the light source. It can be used as a presence detector. Any other applications are possible as well.

In an embodiment, a completely integrated silicon solution may be provided which may be more reliable than a discrete solution. This may allow for a better control due to submicron patterning. Embodiments of the invention may be applied to mobile applications where small packaging is advantageous. According to an embodiment, with a unique process, any kind of wavelength detector can be made as it is only depending of the via diameter. It is even possible to make different detectors on the same silicon wafer. Furthermore, it is possible to use standard semiconductor processes with standard dimensions and standard material. With a silicon wafer, the wavelength detection range may be from 190 nm (or less) to 1100 nm (or more). For higher wavelength detection (above 1 $\mu$m), a device made from germanium may be advantageous.

Embodiments of the invention may have advantages such as excellent linearity of output current as a function of incident light, a spectral response from 190 nm (or less) to 1100 nm (or more), low noise, robustness to mechanical stress, long lifetime, high quantum efficiency (typically 80% or more), and no high voltage required.

As the detector may be designed in a silicon substrate by deep silicon etch, it is possible to reach a high-density detector compared to a planar detector, and it may be possible to compensate a low gain. In an embodiment, it is possible to combine pore etching and PIN junction formation to realize a wavelength filter.

By a unique process, it may be possible to create different diameter holes (just by using a lithography mask), so it is possible to detect several wavelengths. As different diameter holes may be used at the same time, any drift in a lithographic step would be the same for all detector elements, meaning that one single offset would be obtained for all detectors. As it is a silicon process, it is possible to add active and passive components on the silicon. It is possible to get a complete integrated solution of a detector and a signalprocessing module. The combination of a multiple wavelength detector coupled with a signalprocessing module allows sampling.

In an embodiment, as the signal detection is a function of the hole diameter but also the depth of the intrinsic zone, it is possible to design a matrix of detectors with rows of various diameter hole and columns of various depth of intrinsic zone. This may improve the wavelength selection range for a better sampling performance. It is possible to use pore technology to make a very accurate detector thanks to a lithography resolution and to a thin film deposition control.

The manufacturing method may be carried out in CMOS technology, since the described procedures are compatible with CMOS technology.

For any method step, any conventional procedure as known from semiconductor technology may be implemented. Forming layers or components may include deposition techniques like CVD (chemical vapour deposition), PECVD (plasma enhanced chemical vapour deposition), ALD (atomic layer deposition), or sputtering. Removing layers or components may include etching techniques like wet etching, vapour etching, etc., as well as patterning techniques like optical lithography, UV lithography, electron beam lithography, etc.

Embodiments of the invention are not bound to specific materials, so that many different materials may be used. For conductive structures, it may be possible to use metallization structures, silicide structures or polysilicon structures. For semiconductor regions or components, crystalline silicon may be used. For insulating portions, silicon oxide or silicon nitride may be used.

The structure may be formed on a purely crystalline silicon wafer or on an SOI wafer (Silicon On Insulator).

Any process technologies like CMOS, BIPOLAR, BICMOS may be implemented.

The aspects defined above and further aspects of the invention are apparent from the examples of embodiment to be described hereinafter and are explained with reference to these examples of embodiment.

BRIEF DESCRIPTION OF THE DRAWINGS

The invention will be described in more detail hereinafter with reference to examples of embodiment but to which the invention is not limited.

Fig. 1 and Fig. 2 show a geometrical condition illustrating an interaction of electromagnetic radiation with a pore.

Fig. 3 shows intensities for different wavelengths as a function of depth for a via diameter of 0.5 $\mu$m and shows that for certain depths, attenuation is depending of the wavelength.

Fig. 4 shows intensities for different wavelengths as a function of depth for a via diameter of 0.6 $\mu$m, so that by subtracting the intensity of hole of 0.6 $\mu$m and 0.5 $\mu$m it is possible to clearly differentiate wavelengths :

Fig. 5 shows subtraction of intensity of a 0.6 $\mu$m hole minus intensity of a 0.5 $\mu$m hole for 300 nm and 400 nm light and shows that it is possible to extract UV-B light intensity (280 nm to 315 nm) from a light source.

Fig. 6 illustrates a wavelength selective filter according to an exemplary embodiment of the invention.

Fig. 7 to Fig. 13 show cross-sectional views of layer sequences obtained during a method of manufacturing a wavelength selective filter according to an exemplary embodiment of the invention.

Fig. 14 shows a plan view of a wavelength selective filter according to an exemplary embodiment of the invention.

Fig. 15 to Fig. 17 show cross-sectional views of wavelength selective filters in combination with a light emitting diode according to exemplary embodiments of the invention.

Fig. 18 and Fig. 19 show a wavelength selective characteristic of a system according to an exemplary embodiment of the invention.

Fig. 20 shows a cross-sectional view of a wavelength selective filter according to an exemplary embodiment of the invention.

DESCRIPTION OF EMBODIMENTS

The illustration in the drawing is schematical. In different drawings, similar or identical elements are provided with the same reference signs.

Embodiments of the invention allow for diffraction in a micrometric cylindrical trench.

Diffraction refers to various phenomena associated with the bending of waves when they interact with obstacles in their path. Its effects are generally most pronounced for waves where the wavelength is in the order of the size of the diffracting objects. Diffraction is based on the Huygens-Fresnel principle which predicts the future position of a wave when its earlier position is known. Every point on a wave front can be considered as a source of tiny wavelets that spread out in the forward direction at the speed of the wave itself. The new wave front is the envelope of all the wavelets - that is, tangent to them.

In optics, Fresnel diffraction or near-field diffraction is a process of diffraction which occurs when a wave passes through an aperture and diffracts in the near field, causing any diffraction pattern observed to differ in size and shape, relative to the distance. It occurs due to the short distance in which the diffracted waves propagate. When the distance is increased, outgoing diffracted waves become planar and Fraunhofer diffraction occurs. In the following, calculations of the magnitude of the electric field given by Fresnel integral in application of Huygens-Fresnel principle in a cylindrical trench will be explained. The diffracted light from the aperture of the cylindrical trench is absorbed by the silicon lateral surface and by a photon-electron interaction can generate a built-in potential in the semiconductor.

The diffraction angles depend on the wavelength and on the size of the diffracting object. As a consequence, the magnitude of the electric field along the side surface of the cylindrical trench at a fixed distance of the aperture depends on the wavelength.

Next, wave magnitude calculation will be described.

In application of Huygens-Fresnel principle in a circular aperture, the phase and amplitude of each of the Huygens wavelets at each point P in space is given by a double integral in cylindrical coordinates.

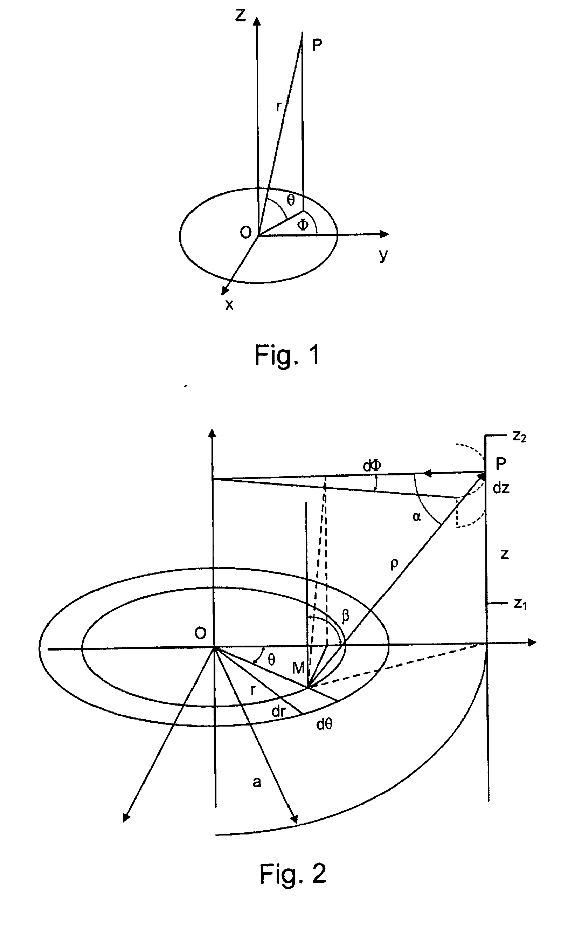

This is indicated schematically in Fig. 1:

$$A(\rho) = \int_\theta \int_r \frac{1}{r} A(\theta. r) \exp j \frac{2\pi r}{\lambda} \cos(r, z) r d\theta dr \qquad (1)$$

In a circular aperture, A(p) is supposed independent of the angle $\Phi$. Along the side surface of the cylindrical trench, the elementary surface at each point P introduces the angle $\alpha$ between $\rho$ and the perpendicular radius.

The double integral is calculated in the cylindrical trench as represented in Fig. 2. Every point on the circular aperture can be considered as a source each point with the same amplitude K.

The phase and amplitude of each of the Huygens wavelets at each point P along the side surface of the cylindrical trench at a fixed distance z of the aperture is given by a double integral

$$A(P) = K \int_\theta \int_r \frac{1}{\rho} \exp j \frac{2\pi\rho}{\lambda} (\cos\alpha)(\cos\beta)\, rd\theta dr \qquad (2)$$

Herein, $\alpha$ is the angle between $\rho$ and the perpendicular radius at P, and a is the radius of the aperture

$$M = \begin{bmatrix} r\cos\theta \\ r\sin\theta \\ 0 \end{bmatrix} \quad P = \begin{bmatrix} a \\ 0 \\ z \end{bmatrix}$$

$$\rho = \left[(a - r\cos\theta)^2 + (r\sin\theta)^2 + z^2\right]^{1/2} \qquad (3)$$

$$\cos\alpha = \left(\frac{a - r\cos\theta}{\rho}\right) \qquad (4)$$

$$\cos\beta = \frac{z}{\rho} \qquad (5)$$

$$A(P) = 2K \int_0^\pi \int_0^a \frac{1}{\rho} \exp j \frac{2\pi\sqrt{(a - r\cos\theta)^2 + (r\sin\theta)^2 + z^2}}{\lambda}$$
$$\left(\frac{a - r\cos\theta}{\rho}\right)\frac{z}{\rho} rd\theta dr \qquad (6)$$

A(P) is a complex number with phase and amplitude at each point P. The complete amplitude in a nano-ring dz along the side surface of the cylindrical trench is:

$$\left[\int_0^{2\pi} A(P) ad\phi\right] dz = a2\pi A(P) dz \qquad (7)$$

The intensity of light at each point P in space is:

$$I(p) = A(P)A(P)^\bullet = |A(P)|^2 \qquad\qquad (8)$$

Simulations of equation (6) are presented with following parameters: aperture radius 0.5 $\mu$m z varies from 0.05 $\mu$m to 2 $\mu$m.

| $\lambda_1$ | $\lambda_2$ | $\lambda_3$ | $\lambda_4$ | $\lambda_5$ |
|---|---|---|---|---|
| 0.3$\mu$m | 0.4$\mu$m | 0.5$\mu$m | 0.6$\mu$m | 0.7$\mu$m |
| $A_{1a}(z)$ | $A_2a(z)$ | $A_{3a}(z)$ | $A_{4a}(z)$ | $A_5a(z)$ |

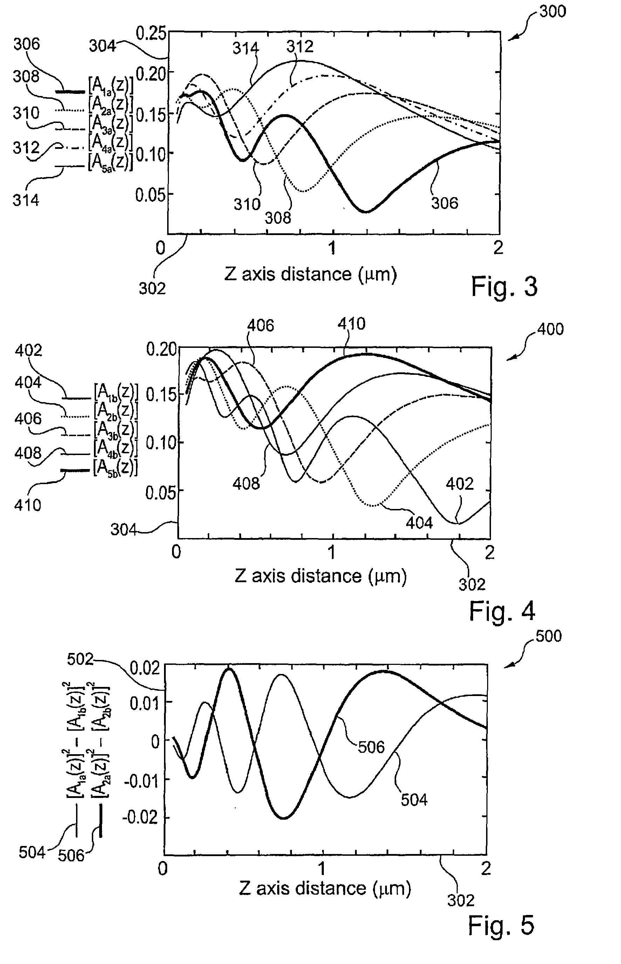

Fig. 3 shows a diagram 300 having an abscissa 302 along which a z axis distance is plotted in $\mu$m. Along an ordinate 304, A-values corresponding to $\lambda_1$ to $\lambda_5$ are plotted.
Aperture radius 0.6 $\mu$m z varies from 0.05 $\mu$m to 2 $\mu$m

| $\lambda_1$ | $\lambda_2$ | $\lambda_3$ | $\lambda_4$ | $\lambda_5$ |
|---|---|---|---|---|
| 0.3$\mu$m | 0.4$\mu$m | 0.5$\mu$m | 0.6$\mu$m | 0.7$\mu$m |
| $A_{1b}(z)$ | $A_{2b}(z)$ | $A_{3b}(z)$ | $A_{4b}(z)$ | $A_{5b}(z)$ |

Fig. 4 shows a diagram 400 having an abscissa 302 along which a z axis distance is plotted in $\mu$m. Along an ordinate 304, A-values corresponding to $\lambda_1$ to $\lambda_5$ are plotted.
Fig. 5 shows a diagram 500 having an abscissa 302 along which a z axis distance is plotted in $\mu$m. Along an ordinate 502, differential amplitudes are plotted.

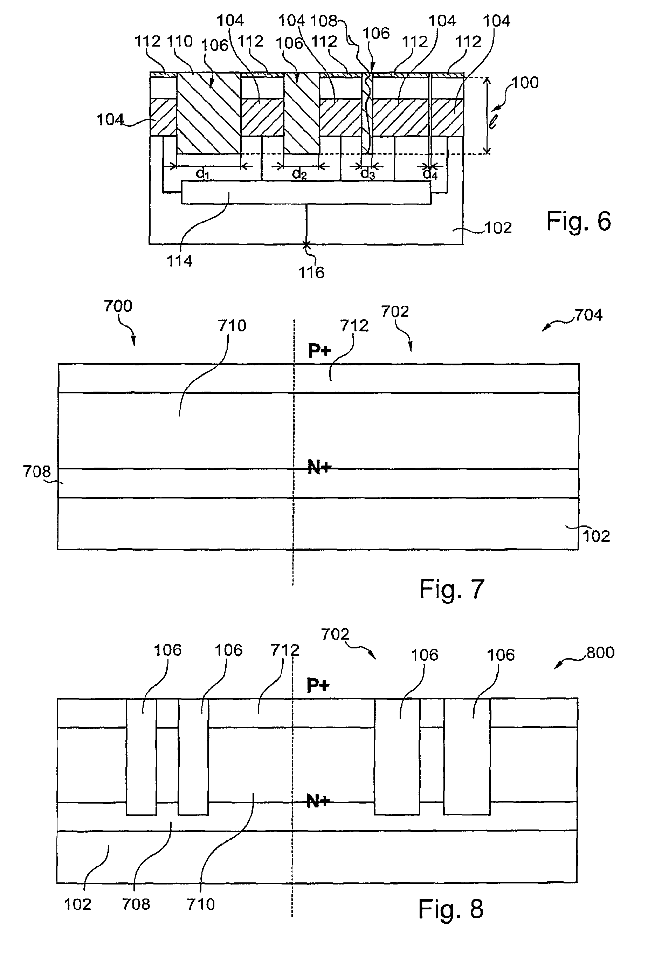

Fig. 6 illustrates a device 100 for detecting a light beam 108 in a wavelength selective manner according to an exemplary embodiment of the invention.
The wavelength selective filter 100 comprises a silicon substrate 102. A photodiode 104 as a light sensitive structure is embedded within the silicon substrate 102. The photodiode 104 may be formed by a number of horizontally deposited planar layers which are doped accordingly. A plurality of trenches or pores 106 are formed in a surface portion of the substrate 102 in order to penetrate through the layers forming the photodiode 104. As can be taken from Fig. 6, the pores 106 have different diameters $d_1 > d_2 > d_3 > d_4$ and are formed by a common lithography and etching procedure in the substrate 102, more precisely in a surface portion of the substrate 102 including the photodiode layer sequence 104. As can be further taken from Fig. 6, all of the pores 106 extend up to the same depth, 1, into the substrate 102.
Since the inner diameters $d_1$, $d_2$, $d_3$, $d_4$ of the pores 106 differ, the light detection properties are wavelength selective and different for each of the pores 106, so that each of the pores 106 is capable of detecting a specific wavelength range of impinging light 108.
The combination of the detection signals of all pores 106 may allow to obtain wavelength-resolved information about a spectrum of the light 108.
The pores 106 are formed parallel to one another in the substrate 102 and have the different diameters $d_1$, $d_2$, $d_3$, $d_4$ in a surface plane of the substrate 102. Since all of them have the same depth 1 in the substrate 102, their aspect ratios are different. The pores 106 are formed as trenches extending perpendicular to a main surface of the substrate 102 and perpendicular to the layer sequence 104 forming the photodiode. The pores 106 are filled with silicon dioxide material or any other semiconductor-based material as an optically transparent material so that the light beam 108 impinging on the device 100 can propagate through the filling material 110.
A patterned cover layer 112 covers surface portions of the layer sequence between adjacent pores 106 to absorb electromagnetic radiation impinging between different ones of the pores 106 to further increase the signal-to-noise ratio. The opaque top layer 112 may further be electrically conductive so as to serve as an electrode for contacting the photodiodes 104 or other components of the integrated circuit 100, if desired or necessary.
A signal processing unit 114 is provided as a buried integrated circuit within the silicon substrate 102 and is supplied with the detection signals from the photodiode 104. The processing circuit 114 may evaluate the wavelength characteristic of the detected light 108 and may output, at an interface 116, a signal indicative of the result of the detection. The output at the interface 116 may alternatively also be used for control purposes, for instance for controlling a light emitting diode.
In the following, referring to Fig. 7 to Fig. 13, a method of manufacturing a device according to an exemplary embodiment will be explained. Such a manufacturing method may result in a colour filter which may serve for light emitting diode control purposes.

In Fig. 7 to Fig. 13, a common silicon substrate 102 is processed to manufacture a $\lambda_1$ wavelength detector 700 and a $\lambda_2$ wavelength detector 702, wherein $\lambda_1 \neq \lambda_1$.

Fig. 7 shows a layer sequence 704 obtained by PIN epitaxy applied to a silicon substrate 102, thereby forming an n+-doped layer 708 on the silicon substrate 102, followed by an intrinsic layer 710 and a p+-doped layer 712. Starting from the silicon substrate, the PIN structure 708, 710, 712 is grown by epitaxy (n+-silicon region 708, intrinsic region 710 and p+-region 712).

In order to obtain a layer sequence 800 shown in Fig. 8, trenches 106 are formed to entirely penetrate through layers 712, 710, and to partially penetrate into layer 708. These trenches 106 may be formed by a deep silicon etch. The deep silicon via holes 106 are formed into the PIN structure 708, 710, 712. Diameters of the holes 106 are different from one to another area in order to detect different wavelengths.

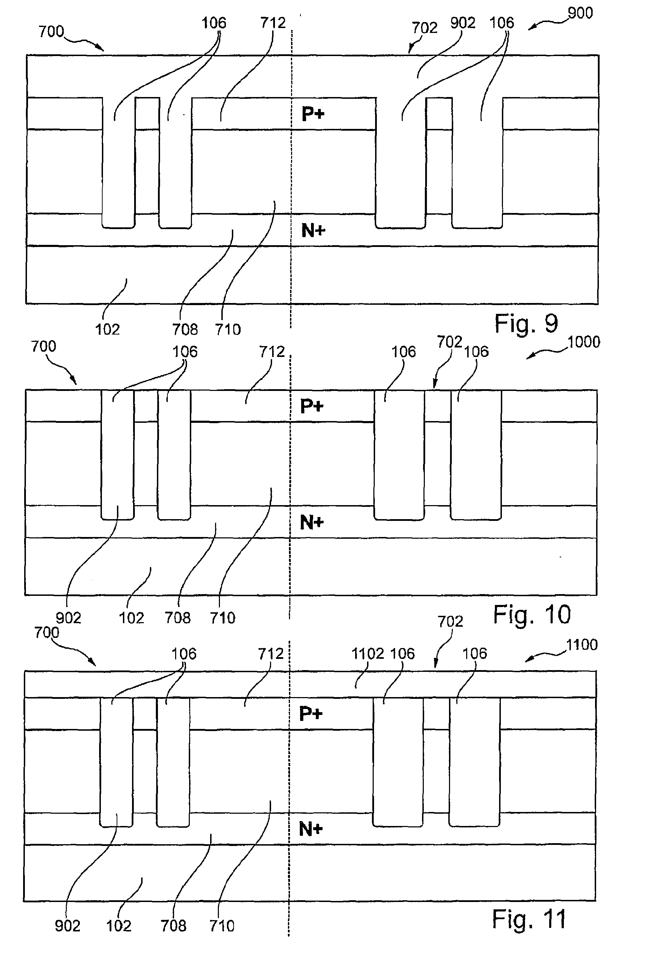

In order to obtain a layer sequence 900 shown in Fig. 9, light transparent silicon dioxide or another transparent semiconductor-based material 902 is deposited on the layer sequence 800 to fill the trenches 106.

In order to obtain a layer sequence 1000 shown in Fig. 10, the deposited silicon oxide material may be etched back, for instance using CMP (Chemical Mechanical Polishing), wherein silicon is at the top of the trench. In another embodiment, when silicon shall be used as a stop layer, it may be possible to add a dummy layer to stop CMP to get selectivity.

Hence, in Fig. 9, the holes 106 are filled with light transparent material 902 (such as undoped silicon, silicon dioxide $SiO_2$), and in Fig. 10 a back etching (etching without litho mask) is performed to remove this material 902 on top of the p+-region 712.

In order to obtain a layer sequence 1100 shown in Fig. 11, an opaque/metal layer 1102 is deposited over the layer sequence 1000. As a material for the metal layer 1102, aluminium or tungsten may be used, for instance.

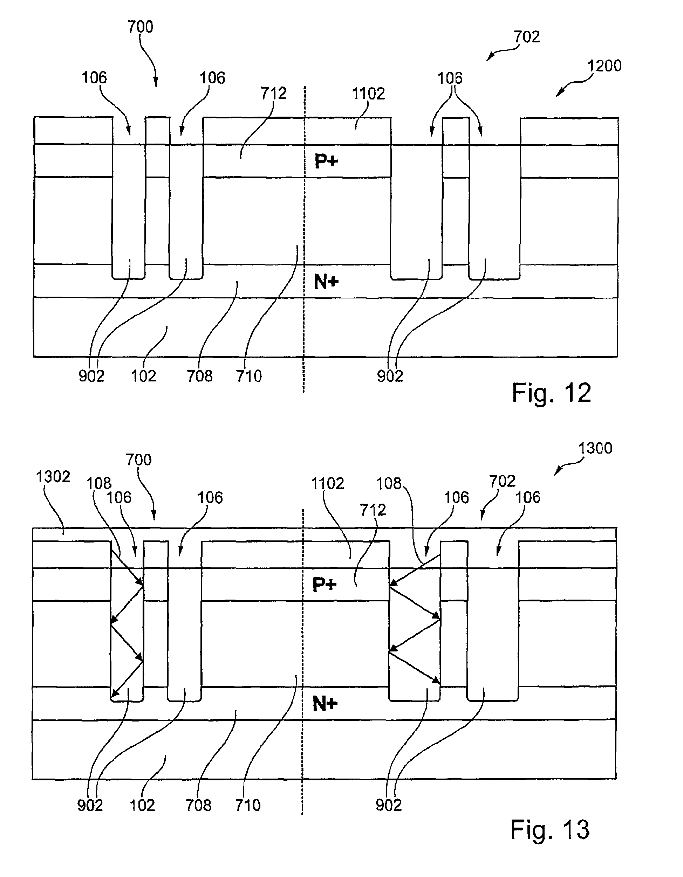

In order to obtain a layer sequence 1200 shown in Fig. 12, the cover layer 1102 is patterned to expose the pores 106.

Referring to Fig. 11 and Fig. 12, the metal layer 1102 or opaque material is deposited and patterned only on the detector area 106.

In order to obtain a device 1300 according to an exemplary embodiment as shown in Fig. 13, a silicon nitride layer 1302 is deposited on a surface of the layer sequence 1200, which silicon nitride layer 1302 acts as an antireflective coating on the openings 108 but also as a passivation layer.

The described process flow does not show the interconnects to collect current from light. Based on theoretical calculations, it is possible to make numerical computing to get values to make the layout of the detector.

A corresponding design may be such that the PIN diodes 708, 710, 712 have an intrinsic region 710 buried between 0.5 $\mu$m and 1 $\mu$m into the silicon with a hole 106 diameter of 600 nm for one circuit part and 500 nm for the other circuit part. For UV-B light source, the current intensity of the 600-nm-hole circuit (A1 and A2 intensities) is higher than for the 500-nm-hole circuit (A1b and A2b intensities).

By triggering the detector to take into account only positive intensities in the area of 0.5 $\mu$m 1 $\mu$m deep (intrinsic region), a simple device can be made to detect UV-B (280 nm to 315 nm) and filter UV-A (315 nm to 400 nm).

An even more accurate filter can be made by optimizing via diameter and combination of different sizes of holes 106.

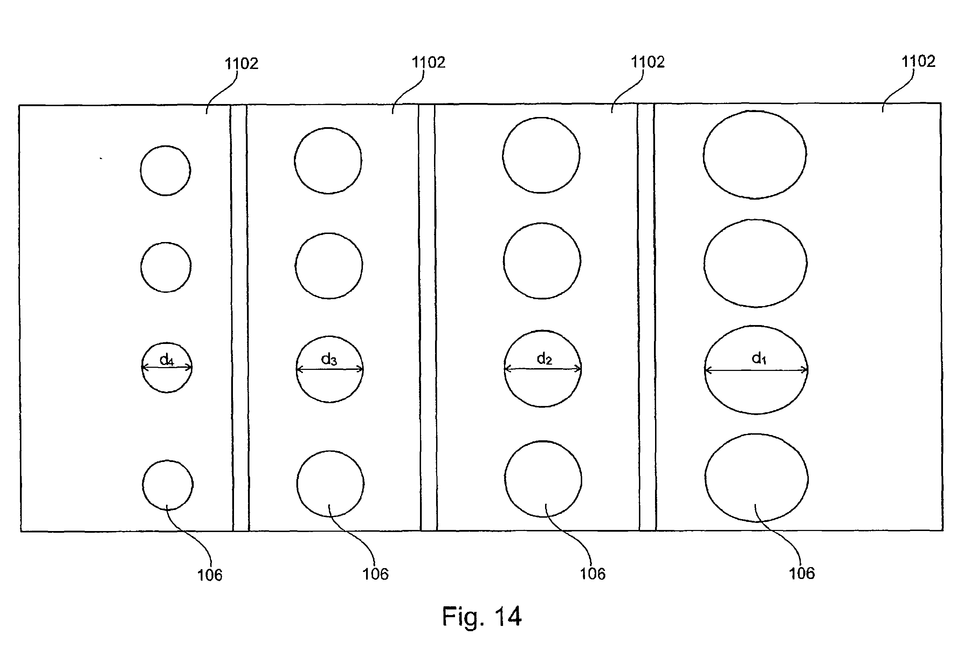

Fig. 14 shows a plan view of a device similar to the device 100 shown in Fig. 6 in which four different pore groups 106 with four different diameters and thus different wavelength selectivity are shown. Four different wavelengths can be detected with the four pores 106 of the different sizes shown in Fig. 14.

Fig. 15 shows a device 1500 according to another exemplary embodiment of the invention.

The device 1500 further comprises a light emitting diode (LED) 1502 emitting light 108. A part of the light 108 is transmitted towards a device 100 for detecting the wavelength composition of the light 108. A corresponding detection result may be transmitted from the device 100 to a signal processing circuit 114 which may generate a control signal for controlling the LED 1500 in a feedback architecture. The light emitting diode 1500 may be connected to the silicon substrate 102 using solder bumps 1504 or the like.

Fig. 16 shows a device according to another exemplary embodiment of the invention which differs from Fig. 15 in that the substrate 102 is substituted by a printed circuit board (PCB) 1602. In the embodiment of Fig. 16, the detector 100 is assembled on the PCB sub-mount 1602 via solder bumps 1504. Also the feedback loop circuitry 114 is connected to the PCB sub-mount 1602 using solder bumps 1504.

Fig. 17 shows a device 1700 according to another exemplary embodiment of the invention.

In this embodiment, the light emitting diode 1502 has a transparent substrate. Thus, the detector 100 can also be arranged under the light emitting diode 1502 as there may be also light emission below the light emitting diode 1502.

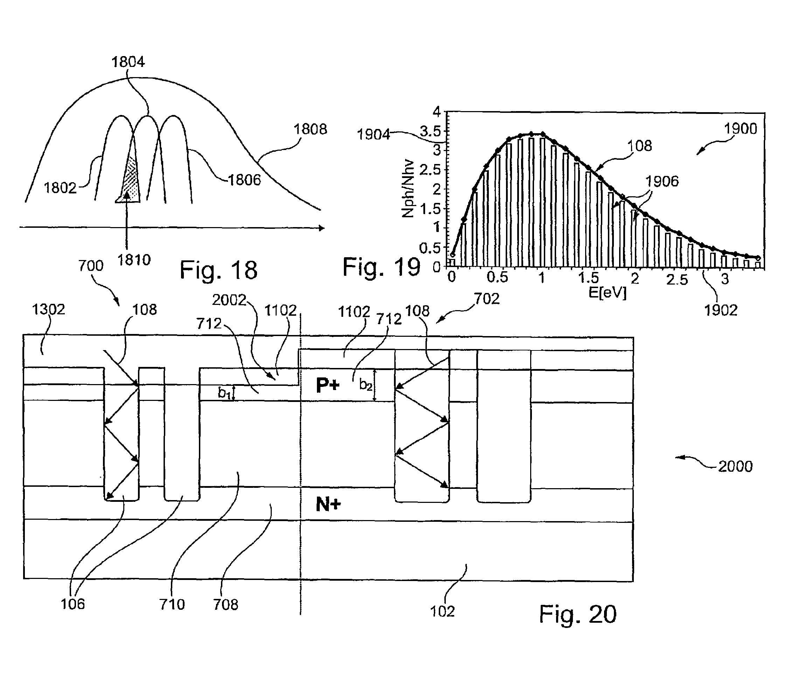

Fig. 18 schematically illustrates how different detectors 1802, 1804, 1806 may detect different wavelength ranges of an overall signal 1808. Reference numeral 1810 illustrates signal sampling from a first detector 1802 and a second detector 1804.

Fig. 19 shows a diagram 1900 having an abscissa 1902 along which a light energy is plotted in electron volts.

Along an ordinate 1904, a spectral distribution of a signal 108 is plotted. Sampling results in measuring the individual wavelength ranges 1906.

Fig. 20 shows a device according to another exemplary embodiment in which a thickness of the layer 712 differs for the two wavelength detectors 700, 702 shown in Fig. 20. For wavelength detector 700, layer 712 has a thickness $b_1$ which is smaller than a thickness $b_2$ for a second wavelength detector 702. Thus, the depth of the intrinsic zone 712 may be tuned by a recess 2002 of $p^+$-layer 712. Such a recess 2002 of the p-region 712 can be manufactured by mask lithography and dry silicon etch.

Finally, it should be noted that the above-mentioned embodiments illustrate rather than limit the invention, and that those skilled in the art will be capable of designing many alternative embodiments without departing from the scope of the invention as defined by the appended claims. In the claims, any reference signs placed in parentheses shall not be construed as limiting the claims. The word "comprising" and "comprises", and the like, does not exclude the presence of elements or steps other than those listed in any claim or the specification as a whole. The singular reference of an element does not exclude the plural reference of such elements and vice-versa. In a device claim enumerating several means, several of these means may be embodied by one and the same item of software or hardware. The mere fact that certain measures are recited in mutually different dependent claims does not indicate that a combination of these measures cannot be used to advantage.

**Claims**

1. A device (100) for detecting electromagnetic radiation, the device (100) comprising
   a substrate (102);
   an electromagnetic radiation sensitive structure (104) arranged on and/or in the substrate (102);
   a plurality of pores (106) formed on and/or in the substrate (102) in such a manner that electromagnetic radiation to be detected propagates through at least a part of the plurality of pores (106) before propagating into the electromagnetic radiation sensitive structure (104), wherein different ones of the plurality of pores (106) differ regarding at least one physical parameter so that each of the plurality of pores (106) is sensitive to an assigned wavelength range of electromagnetic radiation.

2. The device (100) according to claim 1, wherein the plurality of pores (106) are aligned parallel to one another.

3. The device (100) according to claim 1, wherein different ones of the plurality of pores (106) have a different diameter or surface area in a surface plane of the substrate (102).

4. The device (100) according to claim 1, wherein different ones of the plurality of pores (106) extend up to a different depth into the substrate (102).

5. The device (100) according to claim 1, wherein the plurality of pores (106) are grouped into pore groups, wherein pores (106) of each one of the pore groups have a common diameter or surface area in a surface plane of the substrate (102) and extend up to a different depth into the substrate (102), and wherein pores (106) of different ones of the pore groups have a different diameter or surface area in a surface plane of the substrate (102).

6. The device (100) according to claim 1, wherein the plurality of pores (106) are trenches extending perpendicular to a main surface of the substrate (102).

7. The device (100) according to claim 1, wherein the plurality of pores (106) are at least partially filled with a filling material (110) being transparent for the electromagnetic radiation, particularly being optically transparent.

8. The device (100) according to claim 1, wherein the electromagnetic radiation sensitive structure (104) comprises a photodiode structure, particularly a positive-intrinsic-negative photodiode structure.

9. The device (100) according to claim 1, wherein the electromagnetic radiation sensitive structure (104) comprises a stack of layers, wherein different ones of the layers differ from one another regarding a doping profile, wherein the plurality of pores (106) are formed to penetrate through at least a part of the layers.

10. The device (100) according to claim 9, wherein a thickness of at least a part of the layers differs in portions adjacent to different ones of the plurality of pores (106).

11. The device (100) according to claim 1, comprising a patterned cover layer (112) arranged to expose the plurality of pores (106) and to cover surface portions between adjacent ones of the plurality of pores (106).

12. The device (100) according to claim 11, wherein the cover layer (112) comprises at least one of the group consisting of an electrically conductive material, and an opaque material.

13. The device (1300) according to claim 1, comprising an anti-reflective layer (1302) covering at least the plurality of pores (106).

14. The device (100) according to claim 1, comprising a signal processing circuit (114) formed on and/or in the substrate (102) and being adapted for processing detection signals generated by the electromagnetic radiation sensitive structure (104).

15. The device (1500) according to claim 14, comprising an electromagnetic radiation source (1502) adapted for generating electromagnetic radiation and being controlled by a control signal generated by the signal processing circuit (114) based on the detection signals.

16. The device (100) according to claim 1, monolithically integrated in and/or on the substrate (102).

17. The device (100) according to claim 1, wherein the substrate (102) is a semiconductor substrate, particularly one of the group consisting of a group IV semiconductor substrate, a silicon substrate, a germanium substrate, a group III-group V semiconductor substrate, and a GaAs substrate.

18. A method of detecting electromagnetic radiation, the method comprising directing electromagnetic radiation to be detected towards a plurality of pores (106) formed on and/or in a substrate (102) in such a manner that the electromagnetic radiation to be detected propagates through at least a part of the plurality of pores (106);
subsequently propagating the electromagnetic radiation into an electromagnetic radiation sensitive structure (104) arranged on and/or in the substrate (102);
wherein different ones of the plurality of pores (106) differ regarding at least one physical parameter so that each of the plurality of pores (106) is sensitive to an assigned wavelength range of the electromagnetic radiation.

Fig. 1

Fig. 2

Fig. 3

Fig. 4

Fig. 5

Fig. 6

Fig. 7

Fig. 8

700    106   712    702   902   106    900

P+

N+

102    708   710    Fig. 9

700    106    712    106   702 106    1000

P+

N+

902   102   708   710    Fig. 10

700    106   712    1102 106   702   106    1100

P+

N+

902   102   708   710    Fig. 11

700

106          106          712          1102          106          702          1200

P+

N+

902   102   708   710          902

**Fig. 12**

1300

1302   108   700          1102   108   106   702   106
106                712

P+

N+

902   102   708   710          902

**Fig. 13**

Fig. 14

Fig. 15

Fig. 16

Fig. 17

EP 2 172 974 A1

EP 2 172 974 A1

1804

1802    1806

1808

1810

700    Fig. 18

1904

108

1906

1900

Nph/Nhv

E[eV]

702

1902

Fig. 19

1302    108    2002    1102    1102    712    108    702

712    1102

P+    b₂

b₁

2000

P+

N+

N+

106    710    708    102    Fig. 20

Europäisches Patentamt

European Patent Office

Office européen des brevets

## EUROPEAN SEARCH REPORT

Application Number

EP 08 29 0924

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/011955 A1 (BAGGENSTOSS WILLIAM J [US]) 19 January 2006 (2006-01-19) * paragraph [0029] - paragraph [0033] * * abstract; figures 3,4,13 * | 1-18 | INV. H01L27/146 ADD. H01L31/0232 H01L31/0352 |
| X | EP 1 328 024 A2 (SAMSUNG ELECTRONICS CO LTD [KR]) 16 July 2003 (2003-07-16) * paragraph [0049] - paragraph [0050] * * abstract; figures 4,5,6,7,8,9 * * paragraph [0061] - paragraph [0072] * | 1-2, 6-12,15, 17-18 | |
| X | US 6 359 323 B1 (EOM JAE-WON [KR] ET AL) 19 March 2002 (2002-03-19) * abstract; figures 1,6,7 * * column 1 * | 1-3,5-8, 10-12, 14-18 | |
| X | US 2007/284510 A1 (LI JIUTAO [US] ET AL) 13 December 2007 (2007-12-13) * abstract; figure 4 * | 1,17-18 | |
| X | SCHMIDT D J ET AL: "Color filtering metallization for optoelectronic 100nm CMOS circuits" INTERNATIONAL ELECTRON DEVICES MEETING 2003. IEDM. TECHNICAL DIGEST. WASHINGTON, DC, DEC 8 - 10, 2003; [INTERNATIONAL ELECTRON DEVICES MEETING], NEW YORK, NY : IEEE, US, 8 December 2003 (2003-12-08), pages 389-392, XP010684035 ISBN: 978-0-7803-7872-8 | 1,18 | TECHNICAL FIELDS SEARCHED (IPC) H01L |
| A | * the whole document * | 2-17 | |
| A | US 2005/233493 A1 (AUGUSTO CARLOS J [US] AUGUSTO CARLOS J R P [US]) 20 October 2005 (2005-10-20) | 1-18 | |

-/--

The present search report has been drawn up for all claims

| Place of search | Date of completion of the search | Examiner |
|---|---|---|
| The Hague | 16 June 2009 | Heising, Stephan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EUROPEAN SEARCH REPORT**

Application Number

EP 08 29 0924

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DE 195 15 369 A1 (COLOUR CONTROL FARBMESTECHNIK [DE]) 7 November 1996 (1996-11-07) ----- | 1-18 | |
| A | JP 62 123404 A (MITSUBISHI ELECTRIC CORP) 4 June 1987 (1987-06-04) ----- | 1-18 | |
| A | US 2005/040440 A1 (MURAKAMI ICHIRO [JP]) 24 February 2005 (2005-02-24) ----- | 1-18 | |
| A | US 2006/113552 A1 (SONG IN-JAE [KR] ET AL) 1 June 2006 (2006-06-01) ----- | 1-18 | |
| A | ARGUEL P ET AL: "A monolithic phase measurement photodetector" PROCEEDINGS OF IEEE SENSORS 2003. 2ND. IEEE INTERNATIONAL CONFERENCE ON SENSORS. TORONTO, CANADA, OCT. 22 - 24, 2003; [IEEE INTERNATIONAL CONFERENCE ON SENSORS], NEW YORK, NY : IEEE, US, vol. CONF. 2, 22 October 2003 (2003-10-22) , pages 783-786VOL.2, XP010691014 ISBN: 978-0-7803-8133-9 ----- | 1-18 | TECHNICAL FIELDS SEARCHED (IPC) |

The present search report has been drawn up for all claims

| Place of search | Date of completion of the search | Examiner |
|---|---|---|
| The Hague | 16 June 2009 | Heising, Stephan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...............................................................................................
& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 08 29 0924

This annex lists the patent family members relating to the patent documents cited in the above-mentioned European search report.
The members are as contained in the European Patent Office EDP file on
The European Patent Office is in no way liable for these particulars which are merely given for the purpose of information.

16-06-2009

| Patent document cited in search report | | Publication date | Patent family member(s) | | Publication date |
|---|---|---|---|---|---|
| US 2006011955 | A1 | 19-01-2006 | CN<br>EP<br>JP<br>KR<br>US<br>WO | 101019233 A<br>1779432 A1<br>2008507152 T<br>20070042182 A<br>2006081900 A1<br>2006019968 A1 | 15-08-2007<br>02-05-2007<br>06-03-2008<br>20-04-2007<br>20-04-2006<br>23-02-2006 |
| EP 1328024 | A2 | 16-07-2003 | CN<br>JP<br>JP<br>KR<br>US | 1431720 A<br>3825358 B2<br>2003218385 A<br>20030061069 A<br>2003127655 A1 | 23-07-2003<br>27-09-2006<br>31-07-2003<br>18-07-2003<br>10-07-2003 |
| US 6359323 | B1 | 19-03-2002 | JP<br>JP<br>KR<br>TW | 3899432 B2<br>2000228513 A<br>20000044627 A<br>437080 B | 28-03-2007<br>15-08-2000<br>15-07-2000<br>28-05-2001 |
| US 2007284510 | A1 | 13-12-2007 | WO | 2007146035 A1 | 21-12-2007 |
| US 2005233493 | A1 | 20-10-2005 | NONE | | |
| DE 19515369 | A1 | 07-11-1996 | NONE | | |
| JP 62123404 | A | 04-06-1987 | NONE | | |
| US 2005040440 | A1 | 24-02-2005 | CN<br>JP<br>KR<br>TW | 1585134 A<br>2005072097 A<br>20050020633 A<br>251930 B | 23-02-2005<br>17-03-2005<br>04-03-2005<br>21-03-2006 |
| US 2006113552 | A1 | 01-06-2006 | JP<br>KR | 2006165544 A<br>20060059327 A | 22-06-2006<br>01-06-2006 |

EPO FORM P0459

For more details about this annex : see Official Journal of the European Patent Office, No. 12/82

**EP 2 172 974 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5726440 A